# EUROPÄISCHE PATENTSCHRIFT

(11) **EP 3 118 585 B1**
(45) Veröffentlichungstag und Bekanntmachung des Hinweises auf die Patenterteilung: **15.08.2018**
(21) Anmeldenummer: 16001258.9
(22) Anmeldetag: 03.06.2016
(51) Int. Cl.: G01D 5/14

(54) **MAGNETFELDMESSVORRICHTUNG**
MAGNETIC FIELD MEASURING DEVICE
DISPOSITIF DE MESURE DU CHAMP MAGNETIQUE

(30) Priorität: 09.06.2015 DE 102015007190
(43) Veröffentlichungstag der Anmeldung: 18.01.2017
(73) Patentinhaber: TDK-Micronas GmbH, 79108 Freiburg (DE)
(72) Erfinder: Jörg, Franke, 79117 Freiburg (DE)
(74) Vertreter: Koch Müller Patentanwaltsgesellschaft mbH

(56) Entgegenhaltungen:
- DE-A1- 10 118 819
- DE-A1-102007 023 815

## Beschreibung

Die Erfindung betrifft eine Magnetfeldmessvorrichtung.

Aus der EP 2 607 857 A2 und DE 10 2011 121 298 A1 sind jeweils eine Anordnung von einem Hallsensor und einem Magneten bekannt, wobei durch Annäherung einer ferromagnetischen Platte in dem Hallsensor eine Hallspannung erzeugt wird. Ferner sind aus EP 0 916 074 B1, der EP 1 182 461 A2, der WO 2009 / 005237 A2, der EP 2 584 304 A1, der DE 199 46 935 A1, der US 6 917 193 B1 und der WO 2012 / 168635 A1 unterschiedliche Ansätze zur Ausbildung einer Magnetfeldmessvorrichtung bekannt. Weitere Magnetfeldmessvorrichtungen sind aus der DE 101 18 819 A1 und der DE 10 2007 023 815 bekannt.

Vor diesem Hintergrund besteht die Aufgabe der Erfindung darin, eine Vorrichtung anzugeben, die den Stand der Technik weiterbildet.

Die Aufgabe wird durch eine Magnetfeldmessvorrichtung mit den Merkmalen des Patentanspruchs 1 gelöst. Vorteilhafte Ausgestaltungen der Erfindung sind Gegenstand von Unteransprüchen.

Gemäß dem Gegenstand der Erfindung wird eine Magnetfeldmessvorrichtung bereitgestellt, aufweisend einen ersten Halbleiterkörper mit einer in einer ersten x-y Ebene ausgebildeten Oberfläche, wobei der erste Halbleiterkörper an der Oberfläche zwei zueinander beabstandete und entlang einer ersten Verbindungsgeraden angeordnete Magnetfeldsensoren aufweist, und wobei die Magnetfeldsensoren jeweils eine z- Komponente eines Magnetfeldes messen, und die x-Richtung und die y-Richtung und die z-Richtung jeweils orthogonal zueinander ausgebildet sind, und ferner ein erster Magnet mit einer in einer zweiten x-y Ebene ausgebildeten planen Haupterstreckungsfläche und mit einer in einer y-z Ebene ausgebildeten Symmetriefläche, wobei die Richtung der Magnetisierung im Wesentlichen oder exakt parallel zu der Haupterstreckungsfläche und im Wesentlichen oder exakt parallel zu der Symmetriefläche verläuft, und der erste Halbleiterkörper und der erste Magnet starr zueinander fixiert sind, und der erste Halbleiterkörper zu dem ersten Magneten in der x-y-Ebene translatorisch versetzt angeordnet ist und wobei ein in z-Richtung ausgebildete Versatz zwischen der ersten x-y Ebene und der zweiten x-y-Ebene kleiner ist, als eine in der z-Richtung ausgebildete Dicke des ersten Magneten und wobei beide Magnetfeldsensoren in der x-z-Ebene voneinander beabstandet und in der x-z-Ebene entlang der Erstreckung des Nordpols oder entlang der Erstreckung des Südpols angeordnet sind, und wobei bei einer zu der Symmetriefläche unsymmetrischen z-Komponente des Magnetfelds des ersten Magneten die Magnetfeldsensoren zueinander unterschiedliche Signale ausbilden, um die Signale differenziell zu messen, wobei die x-y-Ebene der Magnetfeldsensoren auf der Hälfte der Dicke des ersten Magneten angeordnet ist und wobei sich die in z-Richtung ausgebildete Dicke des Magneten von der in der zweiten x-y-Ebene ausgebildeten Oberseite des Magneten in Richtung der ersten x-y-Ebene und über die erste x-y-Ebene hinaus erstreckt. Es sei angemerkt, dass die Magnetfeldmessvorrichtung vorzugsweise ausgelegt ist, ausschließlich eine in z-Richtung unsymmetrisch zu den Magnetfeldsensoren ausgebildete Komponente des Magnetfeldes des ersten Magneten und oder eines weiteren Magneten zu detektieren. Hierzu muss das Magnetfeld des ersten Magneten mittels eines ferromagnetischen Körpers derart moduliert werden, dass die Magnetfeldlinien des Magneten aus der Ruhelage in der x-y-Ebene wenigstens teilweise und an beiden Magnetfeldsensoren unterschiedlich in die z-Richtung ausgelenkt werden.

Es ist bevorzugt, die in z-Richtung auftretende Komponente des Magnetfeldes mittels einer parallel zu der Verbindungsgeraden der Magnetfeldsensoren in z-Richtung außerhalb der zwischen den beiden Magnetfeldsensoren verlaufenden Symmetrieebene des Aufbaus und hierdurch näher zu einem der beiden Magnetfeldsensoren beabstandete ferromagnetische Körpers zu bewirken. Des Weiteren ist es bevorzugt, dass ohne den in z-Richtung beabstandete ferromagnetische Körper keine oder im Wesentlichen keine z-Komponente des Magnetfeldes des ersten Magneten ausgebildet ist. Des Weiteren sei angemerkt, dass unter Hinzufügung des ferromagnetischen Körpers die Messvorrichtung zu einem Magnetfeldmesssystem weiterbilden lässt. Es versteht sich, dass die Größe der Auslenkung der Magnetfeldlinien aus der x-y Ebene durch den ferromagnetischen Körper bei einem kleinen Abstand in z-Richtung wesentlich größer als bei einem größeren Abstand ist.

Ein Vorteil der erfindungsgemäßen Vorrichtung ist es, dass die Magnetfeldmessvorrichtung mittels zwei zueinander beabstandete Magnetfeldsensoren und der speziellen Lage zu dem Magneten den Signalhub verdoppelt, sobald der zur Symmetrieebene der Magnetfeldmessvorrichtung unsymmetrische Körper zuerst näher an dem einen Magnetfeldsensor und dann näher zu dem anderen Magnetfeldsensor vorbeibewegt wird. Hierzu wird die Differenz aus beiden Signalen ermittelt. Des Weiteren lässt sich ein Offset von magnetischen Gleichfeldern durch die Differenzmessung weitestgehend unterdrücken.

In einer Weiterbildung weist der erste Magnet eine quaderförmige Ausbildung mit zwei in der x-z Ebene als Polflächen ausgebildeten Stirnflächen und zwei in der y-z Ebene ausgebildeten Seitenflächen auf.

In einer Ausführungsform sind die beiden Magnetfeldsensoren entlang der x-Richtung beabstandet, wobei die Verbindungsgerade durch die beiden Magnetfeldsensoren im Wesentlichen oder exakt orthogonal zu der Symmetriefläche und Magnetisierungsrichtung des ersten Magneten angeordnet ist. Anders ausgedrückt, ist der Rand des Halbleiterkörpers parallel oder zumindest im Wesentlichen parallel zu der Magnetisierungsrichtung angeordnet.

Es ist vorteilhaft, dass in x-Richtung die Länge des ersten Halbleiterkörpers im Wesentlichen oder exakt gleich groß bzw. gleich lang ist, wie die Erstreckung des ersten Magneten.

Es ist bevorzugt, dass der erste Halbleiterkörper und der erste Magnet in der x-y Ebene jeweils eine viereckige Form aufweisen, wobei der erste Magnet und der erste Halbleiterkörper in y-Richtung ein Abstand von kleiner als zehn Millimeter vorzugsweise kleiner als zwei Millimeter aufweisen.

Untersuchungen haben gezeigt, dass es vorteilhaft ist, die beiden Magnetfeldsensoren als Hallplatten in oder nahe der ersten x-y Ebene auszubilden.

Die Hallplatten sind hierdurch nur auf z-Komponenten des Magnetfeldes des ersten Magneten sensitiv.

In einer Weiterbildung wird die in z-Richtung auftretende Komponente des Magnetfeldes mittels eines in z-Richtung und unsymmetrisch zur Symmetrieebene beabstandeten ferromagnetischen Körpers erzeugt.

In einer anderen Ausführungsform ist ein zweiter identisch zu dem ersten Halbleiterkörper ausgebildeter Halbleiterkörper vorgesehen. Vorzugsweise sind die beiden Halbleiterkörper in der gleichen x-y-Ebene derart angeordnet, dass die beiden Verbindungsgeraden durch die Magnetfeldsensoren zueinander im Wesentlichen oder exakt parallel sind und die beiden Halbleiterkörper symmetrisch in Bezug auf den dazwischenliegenden ersten Magneten angeordnet sind und jeder der Halbleiterkörper entlang einer der beiden Polflächen des ersten Magneten angeordnet ist.

In einer anderen Weiterbildung ist ein zweiter Magnet vorgesehen, wobei der erste Halbleiterkörper zwischen den unmittelbar einander gegenüberliegenden gleichen Polflächen, entweder zwei Nordpolflächen oder zwei Südpolflächen der beiden Magneten angeordnet ist. Ein Vorteil ist, dass hierdurch die magnetische Flussdichte bei einer Auslenkung der Feldlinien aus der Ruhelage durch die beiden Magnetfeldsensoren erhöht ist. Es ist bevorzugt, die Haupterstreckungsflächen der beiden Magneten in der gleichen x-y-Ebene anzubilden.

Es ist vorteilhaft, in der Oberfläche des jeweiligen Halbleiterkörpers eine integrierte Schaltung auszubilden, wobei die integrierte Schaltung in einer elektrischen Wirkverbindung mit den jeweiligen Magnetfeldsensoren verbunden ist.

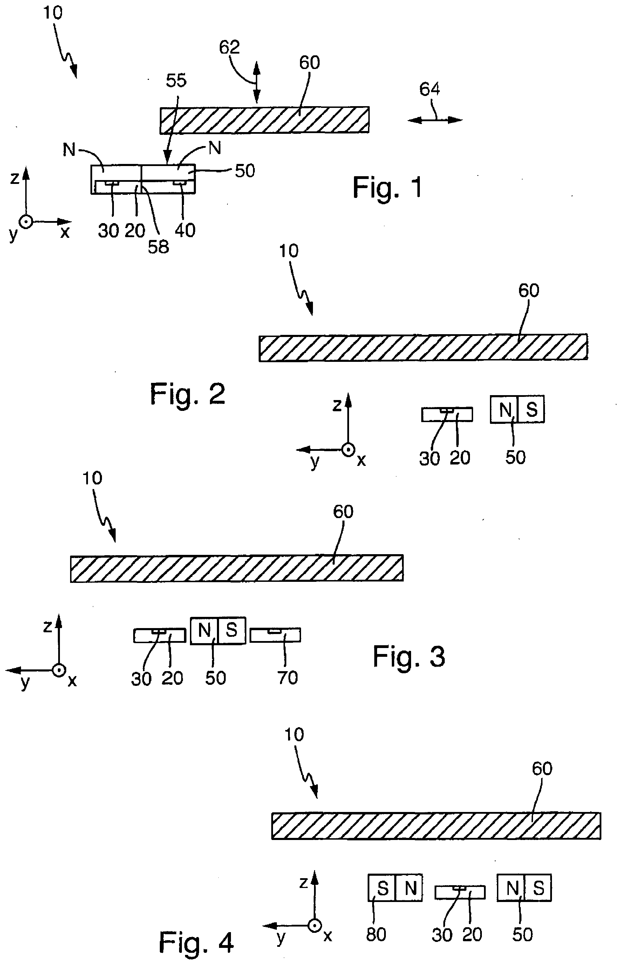

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben auch keine ableitbaren geometrischen Relationen zueinander auf. Aus Gründen der Übersichtlichkeit ist bei den Figuren 1 bis 4 jeweils ein kartesisches Koordinatensystem eingezeichnet. Darin zeigt:
- Figur 1: eine Querschnittsansicht auf eine erste erfindungsgemäße Ausführungsform,
- Figur 2: eine um neunzig Grad gedrehte Querschnittsansicht auf die Ausführungsform dargestellt in der Figur 1,
- Figur 3: eine weitere Ausführungsform mit zwei Halbleiterkörpern,
- Figur 4: eine andere Ausführungsform mit zwei Magneten,
- Figur 5: eine Änderung der magnetischen Flussdichte in Abhängigkeit des x-Abstandes des ferromagnetischen Körpers.
- Figur 6: eine Änderung der magnetischen Flussdichte in Abhängigkeit des z-Abstandes des ferromagnetischen Körpers.

Die Abbildung der Figur 1 zeigt eine Querschnittsansicht auf eine erste erfindungsgemäße Ausführungsform, einer Magnetfeldmessvorrichtung 10 mit einen ersten Halbleiterkörper 20. Der erste Halbleiterkörper 20 weist eine in einer ersten x-y Ebene ausgebildeten Oberfläche auf, wobei der erste Halbleiterkörper 20 an der Oberfläche zwei zueinander beabstandete und entlang einer ersten Verbindungslinie angeordnete Magnetfeldsensoren 30 und 40 aufweist. Die Magnetfeldsensoren 30 und 40 sind jeweils als Hallplatten ausgebildet und messen jeweils ausschließlich eine z- Komponente eines Magnetfeldes eines ersten Magneten 50. Die beiden Magnetfeldsensoren 30 und 40 sind vorliegend nahe der ersten x-y Ebene ausgebildet. Des Weiteren ist eine Symmetriefläche 58 in der y-z Ebene ausgebildet. Die Symmetriefläche 58 trennt die erste Verbindungslinie und die Nordpolfläche des ersten Magneten 50 im Wesentlichen oder exakt in der jeweiligen Mitte.

Der erste Magnet 50 weist eine in einer zweiten x-y Ebene ausgebildete plane Haupterstreckungsfläche 55 auf, wobei die Richtung der Magnetisierung im Wesentlichen parallel oder exakt parallel zu der Haupterstreckungsfläche 55 und zu der Symmetriefläche 58 des ersten Magneten 50 verläuft. Der erste Halbleiterkörper 20 und der erste Magnet 50 sind starr zueinander fixiert sind. Der erste Magnet 50 weist eine quaderförmige Ausbildung mit zwei in der x-z Ebene als Polflächen ausgebildeten Stirnflächen und zwei in der y-z Ebene ausgebildeten Seitenflächen auf.

Vorliegend sind beide Magnetfeldsensoren 30 und 40 in der x-z-Ebene voneinander beabstandet und in der x-z-Ebene entlang der Erstreckung des Nordpols N oder entlang der Erstreckung des Südpols S angeordnet, sodass bei einer auftretenden, zur Symmetriefläche 58 unsymmetrischen z-Komponente des Magnetfelds des ersten Magneten 50 die Magnetfeldsensoren 30 und 40 jeweils unterschiedliche Signale also vorliegend Hallspannungen mit unterschiedlichen, differenziell messbaren Werten ausbilden. Hierzu werden die beiden Magnetfeldsensoren 30 und 40 parallel mit gleicher Betriebsstromrichtung verschaltet und mit einem Differenzverstärker ausgewertet oder seriell verschaltet und mit Betriebsströmen angesteuert, welche zueinander in der Flussrichtung entgegengesetzt sind.

Die beiden Magnetfeldsensoren 30 und 40 sind entlang der x-Richtung zueinander beabstandet. Die erste Verbindungsgerade durch die beiden Magnetfeldsensoren 30 und 40 ist im Wesentlichen oder exakt orthogonal zu der Symmetriefläche 58 des ersten Magneten 50 angeordnet. Es zeigte sich, dass es vorteilhaft ist, in x-Richtung die Länge des ersten Halbleiterkörpers 20 im Wesentlichen oder exakt gleich groß wie die Erstreckung des ersten Magneten 50 auszuführen.

Vorzugsweise ist der erste Halbleiterkörper 20 und der erste Magnet 50 auf einem nicht dargestellten metallischen Träger auch Leadframe genannt angeordnet.

Der erste Halbleiterkörper 20 ist in Bezug auf den ersten Magneten 50 in der x-y-Ebene translatorisch versetzt angeordnet. Es ist bevorzugt, dass ein in z-Richtung ausgebildete Versatz zwischen der ersten x-y Ebene und der zweiten x-y-Ebene kleiner ist, als eine in der z-Richtung ausgebildete Dicke des ersten Magneten. Vorzugsweise ist die x-y Ebene der Magnetfeldsensoren auf der Hälfte der Dicke des ersten Magneten 50 angeordnet ist.

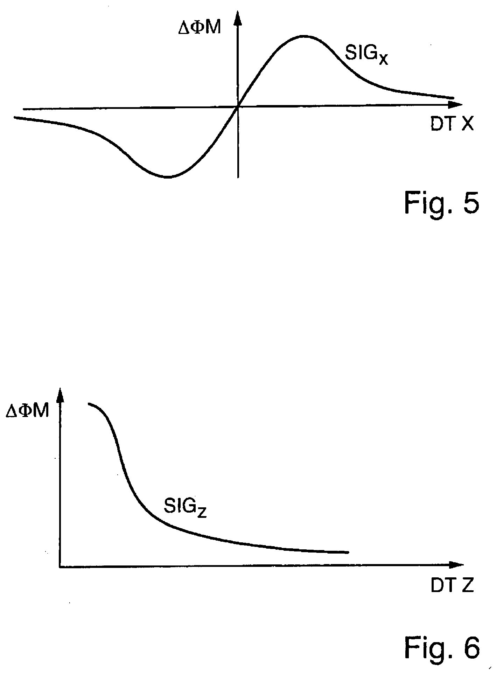

In z-Richtung ist ein von dem ersten Magneten 50 beabstandeter ferromagnetischer Körper 60 unsymmetrisch zur Symmetriefläche 58 angeordnet. Der ferromagnetische Körper 60 ist vorzugsweise weichmagnetisch ausgeführt und lässt sich auch als Target bezeichnen. Die Lage des Targets ist wie mit dem ersten Pfeil 62 dargestellt in der z-Richtung und / oder ist wie mit dem zweiten Pfeil 64 dargestellt in x-Richtung veränderbar. Es versteht sich, dass die aus Gründen der Übersichtlichkeit nicht dargestellten magnetischen Feldlinien in Richtung der z-Achse aufgrund des Targets ausgelenkt werden. Die Stärke der Auslenkung bzw. der Flussänderung durch die beiden Hallplatten in Abhängigkeit der Distanz in x-Richtung ist in der Abbildung 5 detailliert dargestellt. Die Stärke der Auslenkung bzw. der Flussänderung durch die beiden Hallplatten in Abhängigkeit der Distanz in z-Richtung ist in der Abbildung 6 detailliert dargestellt.

Die Figur 2 zeigt eine um neunzig Grad gedrehte Querschnittsansicht auf die Ausführungsform dargestellt in der Figur 1. Im Folgenden werden nur die Unterschiede zu der Abbildung der Figur 1 erläutert. Es zeigt sich, dass der erste Halbleiterkörper 20 und der erste Magnet 50 in der x-y Ebene jeweils eine viereckige Form aufweisen. Der erste Magnet 50 und der erste Halbleiterkörper 20 sind in der y-Richtung beabstandet. Es ist bevorzugt, den Abstand in der y-Richtung kleiner als zwei Millimeter auszuführen.

Die Abbildung der Figur 3 zeigt eine weitere Ausführungsform mit dem ersten Halbleiterkörper 20 und einem in der -y-Richtung beabstandeten zweiten Halbleiterkörper 70. Im Folgenden werden nur die Unterschiede zu der Abbildung zu den vorangegangenen Figuren erläutert. Zwischen den beiden Halbleiterkörpern 20 und 70 ist der erste Magnet 50 angeordnet. Der zweite Halbleiterkörper 70 ist identisch zu dem ersten Halbleiterkörper 20 ausgebildet. Die beiden Halbleiterkörper 20 und 70 in der gleichen x- y-Ebene derart angeordnet sind, so dass die beiden Verbindungsgeraden zueinander im Wesentlichen oder exakt parallel sind und die beiden Halbleiterkörper 20 und 70 symmetrisch in Bezug auf den dazwischenliegenden ersten Magneten angeordnet sind und jeder der Halbleiterkörper 20 und 70 entlang einer der beiden Polflächen des ersten Magneten angeordnet ist. Es ist wünschenswert, dass der Abstand zwischen dem Magneten und den Magnetfeldsensoren in der y-Richtung möglichst gleich ist.

Die Abbildung der Figur 4 zeigt eine andere Ausführungsform mit dem ersten Magneten 50 und einem in der y-Richtung beabstandeten zweiten Magneten 80. Im Folgenden werden nur die Unterschiede zu der Abbildung zu den vorangegangenen Figuren erläutert. Zwischen den beiden Magneten 50 und 80 ist der erste Halbleiterkörper 20 zwischen den unmittelbar einander gegenüberliegenden gleichen Polflächen angeordnet. Der zweite Magnet 80 ist identisch zu dem ersten Magneten 50 ausgebildet. Die beiden Magneten 50 und 80 sind in der gleichen x--y-Ebene derart angeordnet, dass die Polflächen der Magnete 50 und 80 zueinander parallel ausgeordnet sind. Es ist wünschenswert, dass der Abstand zwischen den beiden Magneten 50 und 80 in der y-Richtung möglichst gleich ist.

In der Abbildung der Figur 5 ist eine Änderung der magnetischen Flussdichte ΔΦM in Abhängigkeit des Abstandes DT in X-Richtung zwischen dem Target und dem ersten Magneten 50 und / oder dem zweiten Magneten 80 dargestellt. Es zeigt sich, dass das Signal SIGx der magnetischen Flussdichte ΔΦM bei einer Veränderung des Abstandes DT symmetrisch um die X-Achse ausgebildet ist.

In der Abbildung der Figur 6 ist eine Änderung der magnetischen Flussdichte ΔΦM in Abhängigkeit des Abstandes DT in Z-Richtung zwischen dem Target und dem ersten Magneten 50 und / oder dem zweiten Magneten 80 dargestellt. Im Folgenden werden nur die Unterschiede zu der Abbildung zu der Figur 5 erläutert. Es zeigt sich, dass sich die Flussdichte ΔΦM bei einem geringen Abstand DT in Z-Richtung sehr stark und bei einem großen Abstand DT sehr wenig ändert.

## Patentansprüche

1. Magnetfeldmessvorrichtung (10) aufweisend,
- einen ersten Halbleiterkörper (20) mit einer in einer ersten x-y Ebene ausgebildeten Oberfläche als Oberseite, wobei der erste Halbleiterkörper (20) an der Oberfläche zwei zueinander beabstandete und entlang einer ersten Verbindungeraden angeordnete Magnetfeldsensoren (30, 40) aufweist und wobei die x-Richtung und die y-Richtung und die z-Richtung jeweils orthogonal zueinander ausgebildet sind, und
- einen ersten Magneten (50) mit einer in einer zweiten x-y Ebene ausgebildeten planen Oberseite und mit einer in einer y-z Ebene ausgebildeten Symmetriefläche (58), wobei die Richtung der Magnetisierung im Wesentlichen oder exakt parallel zu der Oberseite und im Wesentlichen oder exakt parallel zu der Symmetriefläche (58) verläuft, und
- der erste Halbleiterkörper (20) und der erste Magnet (50) starr zueinander fixiert sind, und
- der erste Halbleiterkörper (20) zu dem ersten Magneten (50) in einer x-y-Ebene translatorisch versetzt angeordnet ist und wobei ein in z-Richtung ausgebildeter Versatz zwischen der ersten x-y Ebene und der zweiten x-y-Ebene kleiner als eine in der z-Richtung ausgebildete Dicke des ersten Magneten (50) ist,
- sich die in z-Richtung ausgebildete Dicke des Magneten (50) von der in der zweiten x-y Ebene ausgebildeten Oberseite des Magneten in Richtung der ersten x-y Ebene und über die erste x-y Ebene hinaus erstreckt,
- beide Magnetfeldsensoren (30, 40) in der x-z-Ebene voneinander beabstandet und in der x-z-Ebene entlang einer Erstreckung des Nordpols (N) oder entlang einer Erstreckung des Südpols (S) angeordnet sind, wobei
- die in der zweiten x-y Ebene ausgebildete plane Oberseite eine Haupterstreckungsfläche (55) des Magneten (50) ist,
- die Magnetfeldsensoren (30, 40) jeweils eine z- Komponente eines Magnetfeldes messen,
- die Magnetfeldsensoren (30, 40) bei einer zu der Symmetriefläche (58) unsymmetrischen z-Komponente des Magnetfelds des ersten Magneten (50) zueinander unterschiedliche Signale ausbilden, um die Signale differenziell zu messen und
- die x-y Ebene der Magnetfeldsensoren (30, 40) auf der Hälfte der Dicke des ersten Magneten (50) angeordnet ist.

2. Magnetfeldmessvorrichtung (10) nach Anspruch 1, **dadurch gekennzeichnet, dass** der erste Magnet (50) eine quaderförmige Ausbildung mit zwei in der x-z Ebene als Polflächen ausgebildeten Stirnflächen und zwei in der y-z Ebene ausgebildeten Seitenflächen aufweist.

3. Magnetfeldmessvorrichtung (10) nach Anspruch 1 oder Anspruch 2, **dadurch gekennzeichnet, dass** die beiden Magnetfeldsensoren (30, 40) entlang der x-Richtung beabstandet sind und die Verbindungsgerade durch die beiden Magnetfeldsensoren (30, 40) im Wesentlichen oder exakt orthogonal zu der Symmetriefläche (58) des ersten Magneten (50) angeordnet ist.

4. Magnetfeldmessvorrichtung (10) nach einem der vorangegangenen Ansprüche, **dadurch gekennzeichnet, dass** in x-Richtung die Länge des ersten Halbleiterkörpers (20) im Wesentlichen oder exakt gleich groß wie die Erstreckung des ersten Magneten (50) ist.

5. Magnetfeldmessvorrichtung (10) nach einen der vorangegangenen Ansprüche, **dadurch gekennzeichnet, dass** der ersten Halbleiterkörper (20) und der ersten Magnet (50) in der x-y Ebene jeweils eine viereckige Form aufweisen, wobei der erste Magnet (50) und der erste Halbleiterkörper (20) in y-Richtung ein Abstand von kleiner als zwei Millimeter aufweisen.

6. Magnetfeldmessvorrichtung (10) nach einen der vorangegangenen Ansprüche, **dadurch gekennzeichnet, dass** die beiden Magnetfeldsensoren (30, 40) als Hallplatten in oder nahe der ersten x-y Ebene ausgebildet sind.

7. Magnetfeldmessvorrichtung (10) nach einen der vorangegangenen Ansprüche, **dadurch gekennzeichnet, dass** ein zweiter identisch zu dem ersten Halbleiterkörper (20) ausgebildeter Halbleiterkörper (70) vorgesehen ist, wobei die beiden Halbleiterkörper (20, 70) in der gleichen x--y-Ebene derart angeordnet sind, so dass die beiden Verbindungsgeraden zueinander im Wesentlichen oder exakt parallel sind und die beiden Halbleiterkörper (20, 70) symmetrisch in Bezug auf den dazwischenliegenden ersten Magneten angeordnet sind und jeder der Halbleiterkörper (20, 70) entlang einer der beiden Polflächen des ersten Magneten angeordnet ist.

8. Magnetfeldmessvorrichtung (10) nach einem der vorangegangenen Ansprühe, **dadurch gekennzeichnet, dass** ein zweiter Magnet (80) vorgesehen ist und der erste Halbleiterkörper (20) zwischen den unmittelbar einander gegenüberliegenden gleichen Polflächen der beiden Magneten (50, 80) angeordnet ist.

9. Magnetfeldmessvorrichtung (10) nach Anspruch 8, **dadurch gekennzeichnet, dass** die Haupterstreckungsflächen der beiden Magneten (50, 80) in der gleichen x-y-Ebene ausgebildet sind.

10. Magnetfeldmessvorrichtung (10) nach einen der vorangegangenen Ansprüche, **dadurch gekennzeichnet, dass** in der Oberfläche des jeweiligen Halbleiterkörpers (20, 70) eine integrierte Schaltung ausgebildet ist und die integrierte Schaltung in einer elektrischen Wirkverbindung mit den jeweiligen Magnetfeldsensoren (30, 40) steht.

11. Magnetfeldmessvorrichtung (10) nach einem der vorangegangenen Ansprüche, **dadurch gekennzeichnet, dass** die in z-Richtung auftretende Komponente des Magnetfeldes mittels eines in z-Richtung und unsymmetrisch zur Symmetrieebene (58) beabstandete ferromagnetischen Körpers (60) bewirkt ist.

12. Magnetfeldmessvorrichtung (10) nach Anspruch 11, **dadurch gekennzeichnet, dass** ohne den in z-Richtung beabstandeten ferromagnetischen Körper (60) keine z-Komponente des Magnetfeldes vorhanden ist.

## Claims

1. Magnetic field measuring device (10) comprising
- a first semiconductor body (20) with a surface, which is formed in a first x-y plane, as upper side, wherein the first semiconductor body (20) has at the surface two mutually spaced apart magnetic field sensors (30, 40) arranged along a first connecting straight line and wherein the x direction, y direction and z direction are respectively formed orthogonally relative to one another,
- a first magnet (50) with a planar upper side formed in a second x-y plane and with a symmetry surface (58) formed in a y-z plane, wherein the direction of magnetisation extends substantially or exactly parallel to the upper side and substantially or exactly parallel to the symmetry surface (58),
- the first semiconductor body (20) and the first magnet (50) are fixed rigidly relative to one another,
- the first semiconductor body (20) is arranged to be translationally offset with respect to the first magnet (50) in a x-y plane and wherein an offset, which is formed in z direction, between the first x-y plane and the second x-y plane is smaller than a thickness of the first magnet (50) formed in the z direction,
- the thickness of the magnet (50) formed in the z direction extends from the upper side, which is formed in the second x-y plane, of the magnet in the direction of the first x-y plane and beyond the first x-y plane and
- the two magnetic field sensors (30, 40) are spaced from one another in the x-z plane and are arranged in the x-z plane along a length dimension of the north pole (N) or along a length dimension of the south pole (S),
wherein
- the planar upper side formed in the second x-y plane is a main length dimension surface (55) of the magnet (50),
- the magnetic field sensors (30, 40) each measure a z component of a magnetic field,
- the magnetic field sensors (30, 40) in the case of a z component, which is asymmetrical with respect to the symmetry surface (58), of the magnetic field of the first magnet (50) form signals different from one another so as to differentially measure the signals and
- the x-y plane of the magnetic field sensors (30, 40) is arranged at half the thickness of the first magnet (50).

2. Magnetic field measuring device (10) according to claim 1, **characterised in that** the first magnet (50) has a block-shaped construction with two end surfaces formed in the x-z plane as pole surfaces and two side surfaces formed in the y-z plane.

3. Magnetic field measuring device (10) according to claim 1 or claim 2, **characterised in that** the two magnetic field sensors (30, 40) are spaced along the x direction and the connecting straight line through the two magnetic field sensors (30, 40) is arranged substantially or exactly orthogonally to the symmetry surface (58) of the first magnet (50).

4. Magnetic field measuring device (10) according to any one of the preceding claims, **characterised in that** in x direction the length of the first semiconductor body (20) is substantially or exactly the same size as the length dimension of the first magnet (50).

5. Magnetic field measuring device (10) according to any one of the preceding claims, **characterised in that** the first semiconductor body (20) and the first magnet (50) each have a four-cornered shape in the x-y plane, wherein the first magnet (50) and the first semiconductor body (20) have a spacing of less than two millimetres in the y direction.

6. Magnetic field measuring device (10) according to any one of the preceding claims, **characterised in that** the two magnetic field sensors (30, 40) have the form of Hall plates in or near the first x-y plane.

7. Magnetic field measuring device (10) according to any one of the preceding claims, **characterised in that** a second semiconductor body (70) formed identically to the first semiconductor body (20) is provided, wherein the two semiconductor bodies (20, 70) are so arranged in the same x-y plane that the two connecting straight lines are substantially or exactly parallel to one another and the two semiconductor bodies (20, 70) are arranged symmetrically with respect to the intermediately disposed first magnet and each of the semiconductor bodies (20, 70) is arranged along one of the two pole surfaces of the first magnet.

8. Magnetic field measuring device (10) according to any one of the preceding claims, **characterised in that** a second magnet (80) is provided and the first semiconductor body (20) is arranged between the like pole surfaces, which are directly opposite one another, of the two magnets (50, 80).

9. Magnetic field measuring device (10) according to claim 8, **characterised in that** the main length dimension surfaces of the two magnets (50, 80) are formed in the same x-y plane.

10. Magnetic field measuring device (10) according to any one of the preceding claims, **characterised in that** an integrated circuit is formed in the surface of the respective semiconductor body (20, 70) and the integrated circuit is disposed in electrically operative connection with the respective magnetic field sensors (30, 40).

11. Magnetic field measuring device (10) according to any one of the preceding claims, **characterised in that** the component, which arises in z direction, of the magnetic field is produced by means of a ferromagnetic body spaced in z direction and asymmetrically from the plane (58) of symmetry.

12. Magnetic field measuring device (10) according to claim 11, **characterised in that** without the ferromagnetic body (60) spaced in z direction there is no z component of the magnetic field.

## Revendications

1. Dispositif de mesure du champ magnétique (10), présentant
- un premier corps semi-conducteur (20) avec une surface formée dans un premier plan x-y comme côté supérieur, dans lequel le premier corps semi-conducteur (20) présente sur la surface deux capteurs de champ magnétique (30, 40) espacés l'un de l'autre et disposés le long d'une première droite de liaison et dans lequel la direction x et la direction y et la direction z sont chaque fois formées orthogonalement l'une à l'autre, et
- un premier aimant (50) avec un côté supérieur plan formé dans un deuxième plan x-y et avec une face de symétrie (58) formée dans un plan y-z, dans lequel la direction de la magnétisation est essentiellement ou exactement parallèle au côté supérieur et essentiellement ou exactement parallèle à la face de symétrie (58), et
- le premier corps semi-conducteur (20) et le premier aimant (50) sont fixés l'un à l'autre de manière rigide,
- le premier corps semi-conducteur (20) est disposé de façon décalée en translation par rapport au premier aimant (50) dans un plan x-y et dans lequel un décalage formé dans la direction z entre le premier plan x-y et le deuxième plan x-y est inférieur à une épaisseur du premier aimant (50) formée dans la direction z,
- l'épaisseur du premier aimant (50) formée dans la direction z s'étend depuis le côté supérieur de l'aimant formé dans le deuxième plan x-y en direction du premier plan x-y et au-delà du premier plan x-y,
- les deux capteurs de champ magnétique (30, 40) sont espacés l'un de l'autre dans le plan x-z et sont disposés dans le plan x-z le long d'une extension du pôle Nord (N) ou le long d'une extension du pôle Sud (S),
dans lequel
- le côté supérieur plan formé dans le deuxième plan x-y est une face d'extension principale (55) de l'aimant (50),
- les capteurs de champ magnétique (30, 40) mesurent respectivement une composante z d'un champ magnétique,
- les capteurs de champ magnétique (30, 40) forment, dans le cas d'une composante z du champ magnétique du premier aimant (50) asymétrique par rapport à la face de symétrie (58), des signaux différents l'un de l'autre, afin de mesurer les signaux de façon différentielle, et
- le plan x-y des capteurs de champ magnétique (30, 40) est disposé à la moitié de l'épaisseur du premier aimant (50).

2. Dispositif de mesure du champ magnétique (10) selon la revendication 1, **caractérisé en ce que** le premier aimant (50) présente une forme parallélépipédique avec deux faces frontales formées dans le plan x-z en tant que faces polaires et deux faces latérales formées dans le plan y-z.

3. Dispositif de mesure du champ magnétique (10) selon la revendication 1 ou la revendication 2, **caractérisé en ce que** les deux capteurs de champ magnétique (30, 40) sont espacés le long de la direction x et la droite de liaison passant par les deux capteurs de champ magnétique (30, 40) est disposée essentiellement ou exactement orthogonalement à la face de symétrie (58) du premier aimant (50).

4. Dispositif de mesure du champ magnétique (10) selon l'une quelconque des revendications précédentes, **caractérisé en ce que** la longueur du premier corps semi-conducteur (20) dans la direction x est essentiellement ou exactement égale à l'extension du premier aimant (50).

5. Dispositif de mesure du champ magnétique (10) selon l'une quelconque des revendications précédentes, **caractérisé en ce que** le premier corps semi-conducteur (20) et le premier aimant (50) présentent chacun dans le plan x-y une forme carrée, dans lequel le premier aimant (50) et le premier corps semi-conducteur (20) présentent dans la direction y une distance de moins de deux millimètres.

6. Dispositif de mesure du champ magnétique (10) selon l'une quelconque des revendications précédentes, **caractérisé en ce que** les deux capteurs de champ magnétique (30, 40) sont réalisés sous la forme de plaques de Hall dans le ou à proximité du premier plan x-y.

7. Dispositif de mesure du champ magnétique (10) selon l'une quelconque des revendications précédentes, **caractérisé en ce qu'**il est prévu un deuxième corps semi-conducteur (70) configuré de manière identique au premier corps semi-conducteur (20), dans lequel les deux corps semi-conducteurs (20, 70) sont disposés dans le même plan x-y, de telle manière que les deux droites de liaison soient essentiellement ou exactement parallèles l'une à l'autre et que les deux corps semi-conducteurs (20, 70) soient disposés symétriquement par rapport au premier aimant disposé entre eux et que chacun des corps semi-conducteurs (20, 70) soit disposé le long d'une des deux faces polaires du premier aimant.

8. Dispositif de mesure du champ magnétique (10) selon l'une quelconque des revendications précédentes, **caractérisé en ce qu'**il est prévu un deuxième aimant (80) et le premier corps semi-conducteur (20) est disposé entre les mêmes faces polaires des deux aimants (50, 80) directement opposées l'une à l'autre.

9. Dispositif de mesure du champ magnétique (10) selon la revendication 8, **caractérisé en ce que** les faces d'extension principales des deux aimants (50, 80) sont formées dans le même plan x-y.

10. Dispositif de mesure du champ magnétique (10) selon l'une quelconque des revendications précédentes, **caractérisé en ce qu'**un circuit intégré est formé dans la surface du corps semi-conducteur respectif (20, 70) et le circuit intégré est en liaison électrique active avec les capteurs de champ magnétique respectifs (30, 40).

11. Dispositif de mesure du champ magnétique (10) selon l'une quelconque des revendications précédentes, **caractérisé en ce que** la composante du champ magnétique apparaissant dans la direction z est provoquée au moyen d'un corps ferromagnétique (60) espacé dans la direction z et de façon asymétrique par rapport au plan de symétrie (58).

12. Dispositif de mesure du champ magnétique (10) selon la revendication 11, **caractérisé en ce que** sans le corps ferromagnétique (60) espacé dans la direction z, il n'existe aucune composante z du champ magnétique.
